Europäisches Patentamt

European Patent Office

Office européen des brevets

(19)

(11) **EP 1 463 229 A1**

(12) **EUROPEAN PATENT APPLICATION**

(43) Date of publication:
**29.09.2004 Bulletin 2004/40**

(51) Int Cl.⁷: $H04L\ 1/20$, $H04L\ 1/00$

(21) Application number: **03290772.7**

(22) Date of filing: **27.03.2003**

| | |
|---|---|
| (84) Designated Contracting States:<br>**AT BE BG CH CY CZ DE DK EE ES FI FR GB GR HU IE IT LI LU MC NL PT RO SE SI SK TR**<br>Designated Extension States:<br>**AL LT LV MK**<br><br>(71) Applicant: **Motorola Inc.**<br>**Schaumburg, IL 60196 (US)**<br><br>(72) Inventors:<br>• **Simoens, Sébastien**<br>**92330 Sceaux (FR)** | • **Calvese Strinati, Emilio**<br>**92160 Anthony (FR)**<br>• **Boutros, Joseph Jean**<br>**94160 Saint Mandé (FR)**<br><br>(74) Representative: **McCormack, Derek James et al**<br>**Motorola,**<br>**European Intellectual Property Section,**<br>**Law Department,**<br>**Midpoint,**<br>**Alencon Link**<br>**Basingstoke, Hampshire RG21 7PL (GB)** |

(54) **Quality of service metric for communication systems**

(57)     A method of determining Quality of Service (QoS) estimates (120) for at least a first transceiver in a network comprising a soft-output decoder (108).

Within said transceiver, the generation of log-likelihood ratios (LLR) utilises the output of the soft-output decoder. Then, at least a first mean and standard deviation (114) for the positive and/or negative halves of the LLR distribution are determined.

A parameter 'Lambda' (116) is then calculated as a function F operating upon of the division of the mean by the standard deviation, and this parameter is used to determine an estimate of the Quality of Service.

FIG. 1

## Description

### Technical Field

The present invention relates to Quality of Service (QoS) estimates for at least a first transceiver in a network.

### Background

For dynamically configurable transceivers within a network, the ability to adjust transceiver parameters in response to variations in channel conditions is essential both for efficient use of the channel resource and to improve the quality of service (QoS) for the user. In wireless networks (e.g. HIPERLAN/2, 3G), variations within the channel can be due to interference and signal strength, whilst in wired systems (e.g. xDSL) variation can be due to cross-talk.

In general, the reconfiguration of transmission or reception parameters is dependent upon knowledge of current QoS conditions. For example, methods such as Adaptive Modulation and Coding (AMC) or Hybrid Automatic Repeat reQuest (HARQ) attempt to maximise channel throughput given an estimate of the QoS. In non-dynamically configurable transceivers, knowledge of QoS conditions may enable other mitigating techniques.

At the physical layer the QoS is usually defined in terms of the bit error rate (BER), or more often packet error rate (PER).

Obtaining a direct estimate of the PER is generally not desirable, as at low error levels (e.g. near 1%) the time taken to acquire a sufficiently accurate PER estimate is often longer than the duration of a given channel condition.

In the absence of this information however, the modification of the system parameters to improve the QoS for a given channel condition means in principle evaluating all possible contributory parameters to the value of the PER for that scenario (e.g. SNR, channel delay spread, etc).

One means of implementing this evaluation is to generate a look-up table where all known scenario parameters are related to known PER values. However, the combinatorial effect of the parameters restricts the practical use of such a method to simple scenarios such as orthogonal frequency division multiplexing with single antennas.

Information Society Technologies document IST-2000-30116 FITNESS D3.2.1 'Performance analysis of re-configurable MTMR transceivers for WLAN' describes a method of estimating the QoS without direct measurement of the PER, whilst only using a single parameter for the scenario. This results in significantly reduced look-up tables that extend the applicability of the method.

The IST document is based on relating the QoS to the statistics of log-likelihood ratios (LLR) calculated at the output of a space-time maximum a posteriori (MAP) turbo decoder.

It is known that the LLR statistics of a soft output decoder operating in an Add Gaussian White Noise (AWGN) channel can be interpreted as the sum of two Gaussian distributions each of whose mean and variance (-m,$\sigma^2$) and (+m,$\sigma^2$) satisfy the consistency condition.

For space-time turbo codes, the probability density function for the generated LLRs is relatively distinctive for different scenarios. Consequently the IST document argues that the mean and variance of either Gaussian within the generated LLR ($m_{LLR}$,$\sigma^2$) can be related to the BER and thus QoS.

The IST document proposes the use of a single parameter $\chi$ to relate by look-up table to the QoS:

$$\chi = \frac{m_{LLR}^3}{\sigma_{LLR}^2}$$

where $m_{LLR}^3$ is the cube of the mean of the LLR distribution and $\sigma_{LLR}^2$ is the variance of the LLR distribution.

However, the inventors of the present invention have appreciated that in some circumstances the IST parameter $\chi$ fails to reliably indicate the QoS. Specifically:

i) The statistics of the LLR comprise two Gaussian distributions, centered on +m and -m. When the variance is small these may be considered separate and the absolute mean of the positive or negative halves of the LLR distribution $m_{LLR}$ equals |m|. However if the variance is large relative to m then the distributions overlap, in which case $m_{LLR}$ no longer equals |m| and $\chi$ is no longer as accurate.

ii) Calculation of the bit metrics within the space-time MAP turbo decoder requires an approximate knowledge of the communication channel signal to noise ratio (SNR). An a priori SNR error within the range [-3dB,+6dB] will not affect the decoder performance, but significantly affects the statistics of the LLR such that $\chi$ varies considerably. This renders the cited IST method unworkable when a very accurate SNR measure cannot be obtained.

In addition, the inventors of the present invention appreciate that the relationship between any parameter and the PER, BER or QoS should be as linear as possible to simplify the construction of a fixed-point precision look-up table within a practical embodiment of such a method.

The present invention addresses the above problem of estimating the BER, PER or QoS.

## Summary of the Invention

In accordance with a first aspect of the present invention, there is provided a QoS estimation method, as claimed in claim 1.

In accordance with a second aspect of the present invention, there is provided a QoS estimation device, as claimed in claim 10.

Further aspects of the present invention are defined in the dependent claims.

## Brief description of the drawings

FIG. 1 illustrates a method of estimating Quality of Service in accordance with an embodiment of the present invention.

FIG. 2 illustrates Packet Error Rate vs. A for three different channel conditions in accordance with results of an embodiment of the present invention.

Fig. 3 illustrates an apparatus in accordance with an embodiment of present invention.

## Detailed description of the preferred embodiments

The authors of the present invention have independently developed a single parameter A that can be related to the QoS without dependency on a communication channel a priori SNR estimate.

In addition to not requiring any a priori knowledge of the channel conditions or SNR estimate, A is substantially linear for low BER and PER values.

A is applicable to any system employing soft-output decoding, such as 3G, HSDPA, satellite systems or 802.11 HTSG.

In an embodiment of the present invention, a method (100) of determining Quality of Service (QoS) is proposed for at least a first transceiver in a network, comprising a soft-output decoder (108) (for example, a turbo decoder).

Trellis transition probabilities (referred to within the aforementioned IST document) (104) are produced at the input to the decoder, given the observed symbol at the output of the communication channel (102). In order to compute the transition probabilities, an estimate of the communication channel SNR (106) is required in addition to the channel coefficients.

The decoder produces a posteriori probabilities (110) for the 1 or 0 value of each symbol (bit) for input to a hard decision. For example, if for $bit_i$ the decoder outputs $P(bit_i=1)=0.9$ and $P(bit_i=0)=0.1$, then the hard decision is that $bit_i=1$.

The input to the hard decision is typically presented as a log likelihood ratio such as $LLR_i=log(P(bit_i=1)/P(bit_i=0))$. Thus $bit_i=1$ if $LLR_i>0$.

The distribution of LLR values taken over a number of bit decisions therefore reflects the variability in the certainty of bit value. This is related to the bit error rate, packet error rate and quality of service. This relation can then be empirically tabulated.

The LLR distribution (114) can be described as the sum of Gaussian distributions $X_1$ and $X_0$ centred on means +m and -m respectively, considered to be mirror images of each other as it is assumed that channel interference is not value specific.

When $X_1$ and $X_0$ have an absolute mean value that is large compared to the variance, then the absolute mean value of either the positive or negative halves of the LLR distribution, $m_{LLR}$, is approximately equal to the absolute means of $X_1$ and $X_0$.

However, when bit classification errors occur, the variance of $X_1$ and $X_0$ is large enough that they overlap. This overlap distorts the absolute mean value of either the positive or negative halves of the LLR distribution, $m_{LLR}$. As a consequence under these conditions $m_{LLR}$ becomes a less accurate approximation to the absolute means of $X_1$ and $X_0$, as a function of overlap and BER.

The inventors have appreciated the fact that the Gaussian assumption for $X_1$ and $X_0$ can be kept for various constellations, such as any Quadrature Amplitude Modulation (QAM) constellation, and various channels such as Additive White Gaussian Noise (AWGN) channels, with or without the presence of fading.

The inventors of the present invention have also appreciated that the LLR distribution additionally reflects the accuracy of the SNR estimate used within the initial trellis transition probabilities at the input to the decoder. As a consequence, whilst some variations in SNR estimation accuracy may not effect decoding, they may affect the tabulated relationship between LLR and QoS.

In an embodiment of the present invention, a metric (116) based upon the LLR is used that minimises the effect of SNR error and of distribution overlap:

$$\Lambda \ = \ \mathcal{F}\!\left(\frac{m_{LLR}}{\sigma_{LLR}}\right)$$

where $m_{LLR}$ is the mean of the LLR, $\sigma_{LLR}$ is the standard deviation of the LLR and $\mathcal{F}$ is any one of a set of functions.

In one embodiment of the invention, $\mathcal{F}$ is any function that is substantially linear for low BER and/or PER rates (i.e., where $m_{LLR}/(\sigma_{LLR} \gg 1)$.

In a preferred embodiment of the invention, $\mathcal{F} = Log_{10}$ as this improves the correspondence between $\Lambda$ and the QoS estimation values, which are precomputed for fixed SNR intervals, SNR itself being a function of $Log_{10}$.

By developing such a derivation of $\Lambda$, the

present invention minimises the effects of distortion upon the LLR distribution due to errors in SNR estimation or bit classification.

Consequently, the present invention is applicable to more real-world conditions than that described in the prior art.

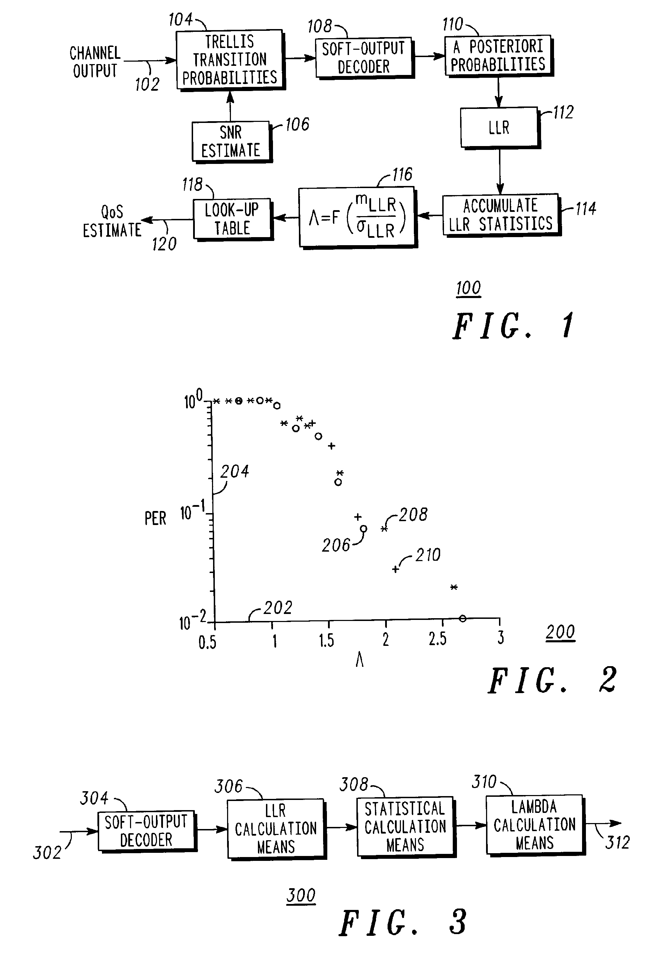

Figure 2 illustrates the consistency of the relationship of A to PER in accordance with the present invention, showing three independent trials denoted O (206), * (208), and + (210) in a non line of sight indoor environment

with 50ns r.m.s. (Root Mean Squared) delay spread for an IEEE 802.11a system, using 64 QAM constellation, Code Rate 1/2. Simulations show that the margin for AMC in IEEE802.11a could be reduced to less than 1dB compared to 4dB required previously, bringing a gain of up to 3dB in the throughput vs. SNR performance.

Figure 3 illustrates an apparatus 300 for implementing an embodiment of the present invention, comprising; a means for soft-output decoding 304, LLR calculation means 306, statistical calculation means 308 and $\Lambda$ calculation means 310. Note that it will be clear to a person skilled in the art that alternative implementations are possible, such as by use of a microprocessor, input and output means, a memory means and microprocessor-implementable instructions comprising the implementation of any or all of the aforesaid means 304, 306, 308 and 310.


## Claims

1. A method of determining Quality of Service (QoS) estimates (120) for at least a first transceiver when operating within a network, comprising a soft-output decoder (108), **characterised by**;

   i) the generation of log-likelihood ratios LLR$_i$=log (P (bit$_i$=1)/P(bit$_i$=0)) (112) utilising the output of the soft-output decoder;
   ii) the generation of at least a first mean and standard deviation (114) for positive and/or negative halves of the LLR distribution;
   iii) calculation of a parameter 'Lambda' ($\Lambda$, 116) as a function F operating upon the division of the mean of step 1.ii) by the standard deviation of step 1.ii) (116); and
   iv) relating parameter Lamba to an indicator of quality of service.

2. A method according to claim 1 wherein F is any function that is substantially linear at low packet error rates for the current system and channel type.

3. A method according to any preceding claims further **characterised by** defining F as Log10.

4. A method according to any preceding claims further characterised wherein the decoder (108) comprises:

   i) a turbo decoder; or
   ii) one of the soft-output component decoders of a turbo decoder.

5. A method according to any preceding claims further **characterised by** comparing Lambda to a look-up table (118) relating values of Lambda to any or all of the following;

   i) Bit Error Rate;
   ii) Packet Error Rate; and
   iii) Quality of Service,

   the selected output of the look-up table being used to inform the adjustment of transceiver parameters.

6. A method according to any of the above claims further **characterised by** the transceiver being either:

   i) a dynamically reconfigurable transceiver; or
   ii) a rate-adaptive transceiver.

7. A method according to any of the above claims, further **characterised by** the use of Lambda to provide input to Adaptive Modulation and Coding (AMC) schemes.

8. A method according to any of claims 1-5, further **characterised by** the use of Lambda to provide input to Hybrid Automatic Repeat reQuest (HARQ) schemes.

9. A method according to any of claims 1-5, further **characterised by** the use of Lambda to provide input to Turbo-HARQ schemes.

10. An apparatus to generate Quality of Service estimates according to a method as claimed in any preceding claims for at least a first transceiver when operating within a network, comprising at least said first transceiver (300) containing a soft-output decoder (304), **characterised by** means to;

    i) calculate said log-likelihood ratios (LLR) utilising the output of the soft-output decoder (306);
    ii) calculate at least a first arithmetic mean and standard deviation for positive and/or negative halves of the LLR distribution (308);
    iii) calculate a parameter 'Lambda' as a function F operating upon of the division of the mean of step 10.ii) by the standard deviation of step 10.ii) (310); and
    iv) relate parameter Lambda to an indicator of quality of service.

**11.** An apparatus according to claim 10 wherein the aforesaid transceiver is a mobile communications terminal.

$$\Lambda = F\left(\frac{m_{LLR}}{\sigma_{LLR}}\right)$$

*100*

*FIG. 1*

*200*

*FIG. 2*

*300*

*FIG. 3*

**European Patent Office**

## EUROPEAN SEARCH REPORT

Application Number

EP 03 29 0772

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (Int.Cl.7) |
| D,X | A. KUZMINSKIY, M. LAMARCA, J.A. LOPEZ, I. MODONESI, F. REY: "PERFORMANCE ANALYSIS OF RE-CONFIGURABLE MTMR TRANSCEIVERS FOR WLAN" INFORMATION SOCIETY TECHNOLOGIES, IST-2000-30116 FITNESS D.3.2.1, DOWNLOADED FROM THE INTERNET HTTP://WWW.IST-FITNESS.ORG (WORDPACKAGE 3.2), 31 August 2002 (2002-08-31), XP002251800 BRUSSELS, BE * SECTION 7.2.6 PAGES 131-135 * --- | 1-11 | H04L1/20 H04L1/00 |
| A | YAMAMOTO N ET AL: "ITERATIVE MAP DECODING OF TURBO CODED OOK AND TURBO CODED BPPM" GLOBECOM'01. 2001 IEEE GLOBAL TELECOMMUNICATIONS CONFERENCE. SAN ANTONIO, TX, NOV. 25 - 29, 2001, IEEE GLOBAL TELECOMMUNICATIONS CONFERENCE, NEW YORK, NY: IEEE, US, vol. 3 OF 6, 25 November 2001 (2001-11-25), pages 1913-1917, XP001054905 ISBN: 0-7803-7206-9 * the whole document * --- | 1-11 | |
| A | US 2001/031024 A1 (WAGNER THOMAS ET AL) 18 October 2001 (2001-10-18) * the whole document * ----- | 1-11 | TECHNICAL FIELDS SEARCHED (Int.Cl.7) H04L |

The present search report has been drawn up for all claims

| Place of search | Date of completion of the search | Examiner |
|---|---|---|
| THE HAGUE | 21 August 2003 | Toumpoulidis, T |

## ANNEX TO THE EUROPEAN SEARCH REPORT
## ON EUROPEAN PATENT APPLICATION NO.

EP 03 29 0772

This annex lists the patent family members relating to the patent documents cited in the above-mentioned European search report.
The members are as contained in the European Patent Office EDP file on
The European Patent Office is in no way liable for these particulars which are merely given for the purpose of information.

21-08-2003

| Patent document cited in search report | Publication date | Patent family member(s) | Publication date |
|---|---|---|---|
| US 2001031024 A1 | 18-10-2001 | DE 10009443 A1<br>EP 1130867 A2<br>JP 2001274855 A | 30-08-2001<br>05-09-2001<br>05-10-2001 |

For more details about this annex : see Official Journal of the European Patent Office, No. 12/82